# EUROPEAN PATENT APPLICATION

(11) **EP 4 794 462 A1**
(43) Date of publication of application: **19.08.2026**
(21) Application number: 24895773.0
(22) Date of filing: 16.08.2024
(51) Int. Cl.: H05K 7/20

(54) **HEAT DISSIPATION SYSTEM AND ENERGY STORAGE SYSTEM**

(30) Priority: 27.11.2023 CN 202311604268
(71) Applicant: Huawei Digital Power Technologies Co., Ltd., Shenzhen, Guangdong 518043 (CN)
(72) Inventor: TAN, Yulong, Shenzhen, Guangdong 518043 (CN); YU, Tao, Shenzhen, Guangdong 518043 (CN); WU, Yingwen, Shenzhen, Guangdong 518043 (CN); LI, Malin, Shenzhen, Guangdong 518043 (CN)
(74) Representative: Isarpatent
(86) International application number: PCT/CN2024/112822
(87) International publication number: WO 2025/112672

(57) **Abstract**

This application provides a heat dissipation system and an energy storage system. The heat dissipation system includes a container body and a heat management module, where the heat management module is disposed in the container body. A partition plate in the container body separates the container body into a temperature control chamber and a control chamber. The temperature control chamber is located above the control chamber. The heat management module includes at least two compressors, at least two water pumps, a plate heat exchanger component, and an electric control box that are located in the control chamber. The compressors and the electric control box are sequentially disposed in a width direction, the plate heat exchanger component and the water pumps are sequentially disposed in the width direction, and the electric control box and the water pumps are disposed sequentially in a length direction. The compressors and the water pumps are separately connected to the plate heat exchanger component, and the compressors and the water pumps are separately connected to the electric control box. The heat management module further includes a liquid cooling unit located in the temperature control chamber, and the plate heat exchanger component and the electric control box are separately connected to the liquid cooling unit. The heat dissipation system in this application can implement water-electricity isolation and a multi-heat management system, so that heat management can still be performed in a scenario in which a single heat management system fails, enhancing reliability of the energy storage system.

## Description

### CROSS-REFERENCE TO RELATED APPLICATIONS

This application claims priority to Chinese Patent Application No. 202311604268.1, filed with the China National Intellectual Property Administration on November 27, 2023 and entitled "HEAT DISSIPATION SYSTEM AND ENERGY STORAGE SYSTEM", which is incorporated herein by reference in its entirety.

### TECHNICAL FIELD

This application relates to the field of energy storage technologies, and in particular, to a heat dissipation system and an energy storage system.

### BACKGROUND

In the background of increasing development of new energy technologies worldwide, various technologies related to energy storage are widely applied, and a manner of using an energy storage container as an energy storage apparatus is widely applied.

With increasing energy density of the energy storage container, a heat dissipation system of the energy storage container needs a heat management module with a stronger and more efficient heat dissipation capability. However, in actual use, apparatuses such as a compressor and a water pump in the heat management module are prone to loss. When the heat management module is faulty, the entire heat management module needs to be disassembled and placed outside the container for replacement and maintenance. This causes an inconvenient operation, and is time-consuming and costly. In addition, a circuit system and a water channel system of a liquid cooling unit are complex, and a safety risk of water-electricity contact is easily caused during replacement and maintenance. This is not conducive to a safe operation of an operator.

### SUMMARY

This application provides a heat dissipation system and an energy storage system, to implement a multi-heat management system of the energy storage system while implementing water-electricity isolation of a heat management module, enhancing reliability of the energy storage system.

According to a first aspect, this application provides a heat dissipation system. The heat dissipation system includes a container body and a heat management module, where the heat management module is disposed in the container body. Specifically, a partition plate is disposed in the container body, the partition plate separates internal space of the container body into a temperature control chamber and a control chamber, and in a height direction of the container body, the temperature control chamber is located above the control chamber. The heat management module includes at least two compressors, at least two water pumps, a plate heat exchanger component, and an electric control box. The at least two compressors, the at least two water pumps, the plate heat exchanger component, and the electric control box are located in the control chamber. The at least two compressors and the electric control box are sequentially disposed in a width direction of the container body, the plate heat exchanger component and the at least two water pumps are sequentially disposed in the width direction, and the electric control box and the at least two water pumps are sequentially disposed in a length direction of the container body. The at least two compressors and the at least two water pumps are separately connected to the plate heat exchanger component, and the at least two compressors and the at least two water pumps are separately connected to the electric control box. In addition, the heat management module further includes a liquid cooling unit. The liquid cooling unit is located in the temperature control chamber, and the plate heat exchanger component and the electric control box are separately connected to the liquid cooling unit.

The heat dissipation system in this application may be used in an energy storage system. The plate heat exchanger component of the heat management module is separately connected to the compressors, the water pumps, and the liquid cooling unit, to implement heat exchange of a heat dissipation loop, a refrigerant loop, and a battery cooling loop, so that the compressors, the water pumps, and the electric control box can be spaced apart. This implements water-electricity isolation. In addition, there may be a plurality of compressors and a plurality of water pumps to implement a multi-heat management system, so that heat management can be performed in a scenario in which a single heat management system fails, enhancing reliability of the energy storage system.

In this application, specific layouts of the compressors, the water pumps, the plate heat exchanger component, and the electric control box may be designed based on an actual requirement. For example, in a possible implementation, the at least two compressors, the at least two water pumps, the plate heat exchanger component, and the electric control box may be distributed in an array.

In a possible implementation, the heat management module may implement a dual-heat management system. Specifically, the at least two compressors may include a first compressor and a second compressor, and the first compressor and the second compressor are sequentially disposed in the width direction. The at least two water pumps may include a first water pump and a second water pump, and the first water pump and the second water pump are sequentially disposed in the width direction. Correspondingly, the plate heat exchanger component includes a first refrigerant channel, a second refrigerant channel, a first water channel, and a second water channel. The first compressor communicates with the first refrigerant channel, the second compressor communicates with the second refrigerant channel, the first water pump communicates with the first water channel, and the second water pump communicates with the second water channel. The dual-heat management system includes two heat management systems, where one heat management system includes the first compressor, the first refrigerant channel, the first water pump, the first water channel, and the liquid cooling unit, and the other heat management system includes the second compressor, the second refrigerant channel, the second water pump, the second water channel, and the liquid cooling unit. The foregoing two heat management systems may be configured to perform heat management when the energy storage system works normally. When one of the heat management systems is faulty or maintained, the other heat management system may still perform heat management on the energy storage system.

In the foregoing dual-heat management system, the plate heat exchanger component may include a first plate heat exchanger module and a second plate heat exchanger module, and the first plate heat exchanger module and the second plate heat exchanger module are isolated from each other. The first refrigerant channel and the first water channel are disposed in the first plate heat exchanger module, and the second refrigerant channel and the second water channel are disposed in the second plate heat exchanger module. Therefore, the first plate heat exchanger module is used in one of the heat management systems, and the second plate heat exchanger module is used in the other heat management system. The first plate heat exchanger module and the second plate heat exchanger module are disposed independently of each other, so that one of the heat management systems can be maintained without affecting an operating status of the other heat management system.

In a possible implementation, the first plate heat exchanger module may specifically include a first refrigerant substrate and a first water channel substrate that are opposite and fastened to each other. The first refrigerant channel is located on the first refrigerant substrate, and the first water channel is located on the first water channel substrate. Similarly, the second plate heat exchanger module may include a second refrigerant substrate and a second water channel substrate that are opposite and fastened to each other. The second refrigerant channel is located on the second refrigerant substrate, and the second water channel is located on the second water channel substrate. The first plate heat exchanger module and the second plate heat exchanger module integrate functions such as an evaporation plate heat exchanger, a condensation plate heat exchanger, a water channel substrate, and a refrigerant substrate. This reduces a quantity of heat management components and pipelines, can save space, and reduces heat exchange between a fluid in a pipeline and an external environment, so that heat dissipation efficiency of the heat dissipation system is improved.

In a possible implementation, the first refrigerant substrate and the second refrigerant substrate are of an integrated structure, and the first water channel substrate and the second water channel substrate are of an integrated structure, so that a structure of the plate heat exchanger component is simplified, and space occupied by the heat dissipation system is reduced.

When the water pumps are disposed, the first water pump and the second water pump may be disposed opposite to each other in the width direction, an axis of the first water pump in the width direction and an axis of the second water pump in the width direction do not overlap, and the first water pump is located on one side that is of the second water pump and that faces the plate heat exchanger component. The first water pump is provided with a first inlet and a first outlet, and the first outlet is located at one end that is of the first water pump and that is close to the plate heat exchanger component. The first outlet communicates with the first water channel, and the first inlet is configured to communicate with a battery cooling channel. The second water pump is provided with a second inlet and a second outlet, and the second inlet is located at one end that is of the second water pump and that is away from the plate heat exchanger component. The second inlet communicates with the battery cooling channel, and the second outlet communicates with the second water channel. In this implementation, the first outlet of the first water pump is close to the plate heat exchanger component, to reduce space occupied by a pipeline between the first water pump and the plate heat exchanger component. The second inlet of the second water pump is far away from the plate heat exchanger component, and may be directly connected to the battery cooling channel, to simplify connection and mounting of the second water pump and the battery cooling channel.

To reduce space occupied by the water pumps, a size of the first water pump may be different from a size of the second water pump. For example, an area of a cross section that is of the first water pump and that is perpendicular to the width direction is different from an area of a cross section that is of the second water pump and that is perpendicular to the width direction. In this way, a flow volume of the first water pump may be different from a flow volume of the second water pump.

In a possible implementation, one side that is of the electric control box and that is far away from the compressors may be in hinged connection to the container body, so that the water pump may be maintained or replaced by rotating the electric control box out of the container body.

In a possible implementation, the liquid cooling unit may specifically include a heat dissipater and a fan. The fan is located on one side that is of the heat dissipater and that is away from the control chamber, and a filter is disposed on a surface of the heat dissipater. The plate heat exchanger component may further include a third water channel, and the heat dissipater communicates with the third water channel.

In a possible implementation, the container body includes a top wall, a bottom wall, and four side walls that are enclosed, the top wall and the bottom wall are disposed in parallel, and the four side walls are perpendicular to the top wall. In the foregoing four side walls, a side wall located on one side that is of the electric control box and that is away from the water pumps is provided with a cabinet door. In this way, after opening the cabinet door, an operator can directly maintain or replace the compressors and the electric control box.

According to a second aspect, this application further provides an energy storage system. The energy storage system includes an energy storage cabinet, a power converter, and the heat dissipation system in the first aspect. A plurality of battery packs are disposed in the energy storage cabinet. The heat dissipation system is disposed at one end of the energy storage cabinet, the plate heat exchanger component is located on one side that is of the at least two compressors and that faces the energy storage cabinet, and the at least two water pumps are located on one side that is of the electric control box and that faces the energy storage cabinet. The power converter is configured to charge or discharge the plurality of battery packs in the energy storage cabinet. In the energy storage system in this application, the heat dissipation system can implement water-electricity isolation, and implement a multi-heat management system for the energy storage cabinet, so that heat management can still be performed on the energy storage cabinet in a scenario in which a single heat management system fails, enhancing reliability of the energy storage system.

In a possible implementation, the energy storage cabinet includes a cabinet body, and the plurality of battery packs are accommodated in the cabinet body. A battery cooling channel is provided in the cabinet body, and the at least two water pumps of the heat dissipation system separately communicate with the battery cooling channel. In this implementation, the cabinet body has continuous space for mounting the battery packs, and the heat dissipation system is disposed on one side of the cabinet body. Therefore, space utilization of the cabinet body can be improved, to help improve energy storage effect and integration of the energy storage cabinet. In addition, unified heat dissipation management can be performed on the plurality of battery packs in the cabinet body, to improve heat dissipation efficiency.

### BRIEF DESCRIPTION OF DRAWINGS

FIG. 1 is a diagram of an energy storage system according to an embodiment of this application;
FIG. 2 is a diagram of a heat dissipation system and an energy storage cabinet according to an embodiment of this application;
FIG. 3 is a diagram of a heat dissipation system and an energy storage cabinet according to an embodiment of this application;
FIG. 4 is another diagram of a heat dissipation system according to an embodiment of this application;
FIG. 5 is another diagram of a heat dissipation system according to an embodiment of this application;
FIG. 6 is a diagram of a plate heat exchanger component according to an embodiment of this application; and
FIG. 7 is another diagram of a plate heat exchanger component according to an embodiment of this application.

### Reference numerals:

10: Energy storage system
11: Energy storage cabinet
12: Power converter
13: Heat dissipation system
111: Cabinet body
112: Battery pack
131: Container body
132: Heat management module
1311: Partition plate
1312: Temperature control chamber
1313: Control chamber
1321: Liquid cooling unit
1322: Compressor
1323: Water pump
1324: Plate heat exchanger component
1325: Electric control box
13211: Heat dissipater
13212: Fan
1322a: First compressor
1322b: Second compressor
1323a: First water pump
1323b: Second water pump
1324a: First plate heat exchanger module
1324b: Second plate heat exchanger module
13241: First refrigerant substrate
13242: First water channel substrate
13243a: First multi-way valve
13243b: Second multi-way valve
13244: First gas-liquid separator
13245a: First expansion valve
13245b: Second expansion valve
13246: Third water channel substrate
13247: Cooler
13248: Condenser
13249: Suction port
13250: Air exhaust port
13251: Fluorine injection nozzle

### DESCRIPTION OF EMBODIMENTS

To make the objectives, technical solutions, and advantages of this application clearer, the following further describes this application in detail with reference to the accompanying drawings.

It should be noted that terms used in the following embodiments are merely intended to describe specific embodiments, but are not intended to limit this application. The terms "one", "a" "the", "the foregoing", "this", and "the one" of singular forms used in this specification and the appended claims of this application are also intended to include expressions such as "one or more", unless otherwise specified in the context clearly.

Reference to "an embodiment", "some embodiments", or the like described in this specification indicates that one or more embodiments of this application include a specific feature, structure, or characteristic described with reference to embodiments. Therefore, statements such as "in an embodiment", "in some embodiments", "in some other embodiments", and "in other embodiments" that appear at different places in this specification do not necessarily mean reference to a same embodiment. Instead, the statements mean "one or more but not all of embodiments", unless otherwise specifically emphasized in another manner. The terms "include", "contain", "have", and their variants all mean "include but are not limited to", unless otherwise specifically emphasized in another manner.

As energy density of an energy storage container becomes higher, requirements on heat dissipation efficiency and effect of a heat management module are also increasingly high. For a large energy storage device such as the energy storage container, a structure of a liquid cooling heat dissipation system in the heat management module is complex, and an overall size is large. Due to limited internal space of the container, during actual maintenance, if the liquid cooling heat dissipation system is faulty, a shutdown is needed for maintenance, and the entire heat management module needs to be disassembled for maintenance and replacement of parts. Operations are complex and affect normal running of a unit. In addition, a circuit system and a water channel system of the liquid cooling heat dissipation system are disposed in a cross manner. This poses a safety risk.

Therefore, this application provides a heat dissipation system and an energy storage system, to implement a multi-heat management system of an energy storage system while implementing water-electricity isolation of a heat management module, enhancing reliability of the energy storage system.

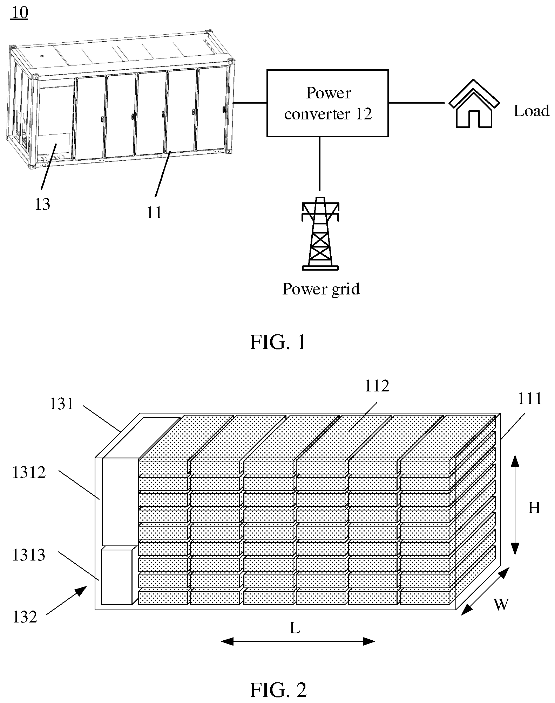

FIG. 1 is a diagram of an energy storage system according to an embodiment of this application. As shown in FIG. 1, the energy storage system 10 includes an energy storage cabinet 11, a power converter 12, and a heat dissipation system 13. A plurality of battery packs are disposed in the energy storage cabinet 11. The heat dissipation system 13 is disposed at one end of the energy storage cabinet 11 and may be configured to dissipate heat for the battery packs in the energy storage cabinet 11. The power converter 12 is configured to charge or discharge the plurality of battery packs in the energy storage cabinet 11. For example, the power converter 12 may be configured to convert an alternating current output by an external alternating current power supply into a direct current and output the direct current to the energy storage cabinet 11, and/or the power converter 12 may be configured to convert a direct current output by the energy storage cabinet 11 into an alternating current and output the alternating current to a load or a grid. In the energy storage system 10 in this application, a heat management module of the heat dissipation system 13 can implement water-electricity isolation and a multi-heat management system, so that heat management can be performed on the energy storage cabinet 11 in a scenario in which a single heat management system fails, enhancing reliability of the energy storage system 10.

The energy storage system 10 may be used in but is not limited to industrial and commercial energy storage scenarios such as small-scale industry and commerce (for example, a small factory), medium-scale industry and commerce, large-scale industry and commerce, a photovoltaic energy storage charging station, and a small or medium microgrid (for example, an island), and power station scenarios such as a wind/solar energy storage power station, a grid energy storage power station, and a large microgrid, to store and release electric energy. During actual application, the energy storage cabinet 11 may be in a form of a charging station, an energy storage container, or the like. The following describes in detail by using a heat dissipation system 13 used in an energy storage container as an example.

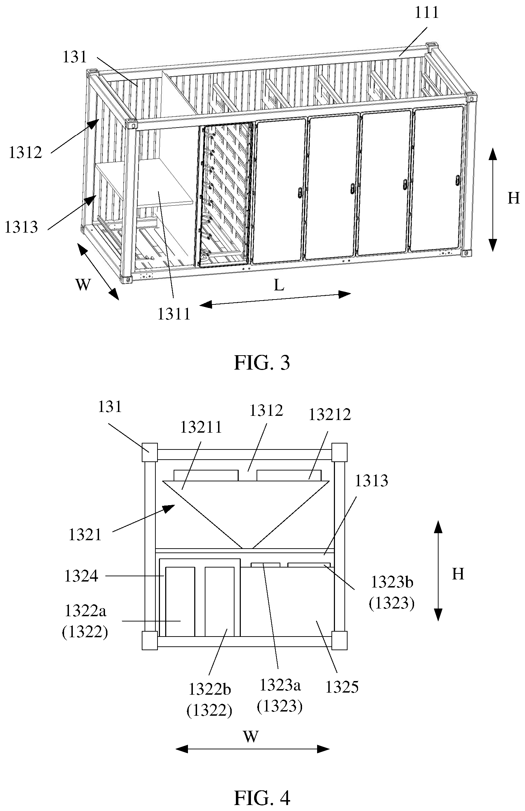

FIG. 2 is a diagram of the heat dissipation system and the energy storage cabinet according to an embodiment of this application. FIG. 3 is a diagram of the heat dissipation system and the energy storage cabinet according to an embodiment of this application. As shown in FIG. 2 and FIG. 3, in an embodiment, the energy storage cabinet 11 includes a cabinet body 111, and the foregoing plurality of battery packs 112 are accommodated in the cabinet body 111. The heat dissipation system 13 is located on one side of the cabinet body 111, so that the cabinet body 111 has continuous space for mounting the battery packs 112. Therefore, space utilization of the cabinet body 111 can be improved, to help improve energy storage effect and integration of the energy storage system 10. In addition, unified heat dissipation management can be performed on the plurality of battery packs 112 in the cabinet body 111, to improve heat dissipation efficiency. A battery cooling channel is provided in the cabinet body 111, and the heat dissipation system 13 communicates with the battery cooling channel and is configured to perform heat management on the battery packs 112 in the cabinet body 111.

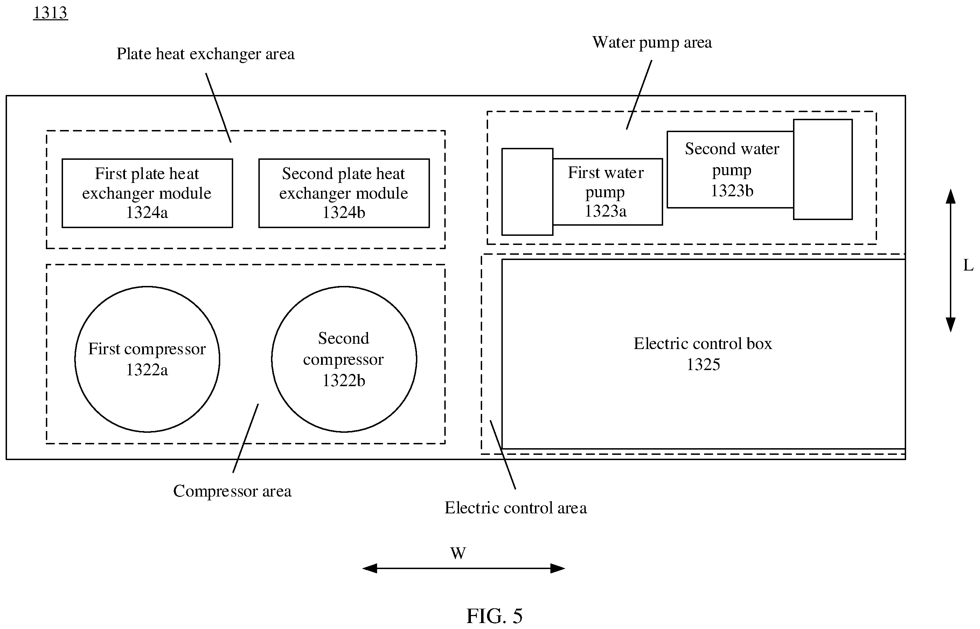

FIG. 4 is another diagram of the heat dissipation system according to an embodiment of this application. FIG. 5 is another diagram of the heat dissipation system according to an embodiment of this application. As shown in FIG. 4 and FIG. 5, the heat dissipation system 13 includes a container body 131 and a heat management module 132. The heat management module 132 is disposed in the container body 131. During actual application, the container body 131 of the heat dissipation system 13 may be fastened to the cabinet body 111 of the energy storage cabinet 11 in a manner of welding or threaded connection, or the container body 131 and the cabinet body 111 may be of an integrated structure. Specifically, a partition plate 1311 is disposed in the container body 131, and the partition plate 1311 separates the container body 131 into a temperature control chamber 1312 and a control chamber 1313. The temperature control chamber 1312 and the control chamber 1313 are sequentially distributed in a height direction H of the container body 131, and the temperature control chamber 1312 is located above the control chamber 1313. The heat management module 132 includes a liquid cooling unit 1321, at least two compressors 1322, at least two water pumps 1323, a plate heat exchanger component 1324, and an electric control box 1325. The liquid cooling unit 1321 is located in the temperature control chamber 1312, and the at least two compressors 1322, the at least two water pumps 1323, the plate heat exchanger component 1324, and the electric control box 1325 are located in the control chamber 1313.

Still refer to FIG. 4 and FIG. 5. In the control chamber 1313, the at least two compressors 1322 and the electric control box 1325 are sequentially disposed in a width direction W of the container body 131, the plate heat exchanger component 1324 and the at least two water pumps 1323 are sequentially disposed in the width direction W, and the electric control box 1325 and the at least two water pumps 1323 are sequentially disposed in a length direction L of the container body 131. Specifically, when the heat management module 132 is mounted, the liquid cooling unit 1321, the at least two compressors 1322, and the at least two water pumps 1323 are separately connected to the plate heat exchanger component 1324, and the liquid cooling unit 1321, the at least two compressors 1322, and the at least two water pumps 1323 are separately connected to the electric control box 1325. Therefore, the plate heat exchanger component 1324 may implement heat exchange of a heat dissipation loop, a refrigerant loop, and a battery cooling loop, so that the compressors 1322, the water pumps 1323, and the electric control box 1325 can be spaced apart. This implements water-electricity isolation. In addition, specifically, there may be a plurality of compressors 1322 and a plurality of water pumps 1323, to implement a multi-heat management system, so that heat management can be performed in a scenario in which a single heat management system fails, enhancing reliability of the energy storage system 10.

It should be noted that, during actual application, the energy storage system 10 may be placed on the ground. A surface that is of the energy storage system 10 and that is in contact with the ground is a bottom surface. Dimensions of the bottom surface include a length and a width, where a length direction of the bottom surface is the same as the length direction L of the cabinet body 111 and the container body 131, and a width direction of the bottom surface is the same as the width direction W of the cabinet body 111 and the container body 131. A dimension that is of the cabinet body 111 and the container body 131 and that is perpendicular to the bottom surface is a height, and the height direction is the height direction H of the cabinet body 111 and the container body 131.

In this embodiment of this application, the plate heat exchanger component 1324 integrates functions such as an evaporation plate heat exchanger, a condensation plate heat exchanger, a water channel substrate, and a refrigerant substrate. This reduces a quantity of heat management components and pipelines, and can save space. In addition, heat exchange of the heat dissipation loop, the refrigerant loop, and the battery cooling loop is integrated in the plate heat exchanger component 1324, so that heat exchange between a fluid in a pipeline and an external environment can be reduced, and heat dissipation efficiency of the heat dissipation system 13 is improved. In the foregoing embodiment, internal space of the control chamber 1313 may be divided into a compressor area, an electric control area, a plate heat exchanger area, and a water pump area that communicate with each other. Specific layouts of the compressors 1322, the water pumps 1323, the plate heat exchanger component 1324, and the electric control box 1325 may be designed based on an actual requirement. For example, in an embodiment, the at least two compressors 1322, the at least two water pumps 1323, the plate heat exchanger component 1324, and the electric control box 1325 may be distributed in an array. That is, the compressor area, the electric control area, the plate heat exchanger area, and the water pump area are distributed in a rectangular array. The compressor area and the electric control area are disposed side by side in the width direction W of the container body 131. The plate heat exchanger area and the water pump area are disposed side by side in the width direction W of the container body 131. The plate heat exchanger area and the compressor area are disposed side by side in the length direction L of the container body 131. The water pump area and the electric control area are disposed side by side in the length direction L of the container body 131.

During actual application, the compressors 1322 and the water pumps 1323 need to be maintained periodically. The container body 131 includes a top wall, a bottom wall, and four side walls that are enclosed, the top wall and the bottom wall are disposed in parallel, and the four side walls are perpendicular to the top wall. In the foregoing four side walls, a side wall located on one side that is of the electric control box 1325 and that is away from the water pumps 1323 is provided with a cabinet door. In this way, when the cabinet door of the control chamber 1313 is opened, an operator may correspondingly enable and disable each heat management system by operating the electric control box 1325, to directly maintain or replace the compressors 1322 without stopping the heat management system. In an embodiment, one side that is of the electric control box 1325 and that is far away from the at least two compressors 1322 may be in hinged connection to the container body 131. In this way, the area of the water pumps 1323 can be maintained only by rotating the electric control box 1325 out of the container body 131, and the entire electric control box 1325 does not need to be disassembled, further simplifying a maintenance operation.

In addition, in this application, at least one of a filter, a three-way valve, a liquid refill pump, a heater, another valve, and a sensor may be further disposed in the water pump area, so that a water channel component may be disposed in the water pump area, to implement integration of a water channel of the heat management system.

The heat management module 132 in this application may implement the multi-heat management system. As shown in FIG. 5, in an embodiment, the heat management module 132 may implement a dual-heat management system. Specifically, the at least two compressors 1322 may include a first compressor 1322a and a second compressor 1322b, and the first compressor 1322a and the second compressor 1322b are sequentially disposed in the width direction W. That is, the first compressor 1322a and the second compressor 1322b are arranged side by side. When the cabinet door is opened, the operator may directly maintain the first compressor 1322a and the second compressor 1322b. The at least two water pumps 1323 may include a first water pump 1323a and a second water pump 1323b, and the first water pump 1323a and the second water pump 1323b are successively disposed in the width direction W. Correspondingly, the plate heat exchanger component 1324 includes a first refrigerant channel, a second refrigerant channel, a first water channel, and a second water channel. The first compressor 1322a communicates with the first refrigerant channel, the second compressor 1322b communicates with the second refrigerant channel, the first water pump 1323a communicates with the first water channel, and the second water pump 1323b communicates with the second water channel. The dual-heat management system includes a first heat management system and a second heat management system. The first heat management system includes the first compressor 1322a, the first refrigerant channel, the first water pump 1323a, the first water channel, and the liquid cooling unit 1321. The second heat management system includes the second compressor 1322b, the second refrigerant channel, the second water pump 1323b, the second water channel, and the liquid cooling unit 1321. The first heat management system and the second heat management system may be configured to perform heat management when the energy storage cabinet works normally. When any heat management system is faulty or maintained, the other heat management system may still perform heat management on the energy storage system 10.

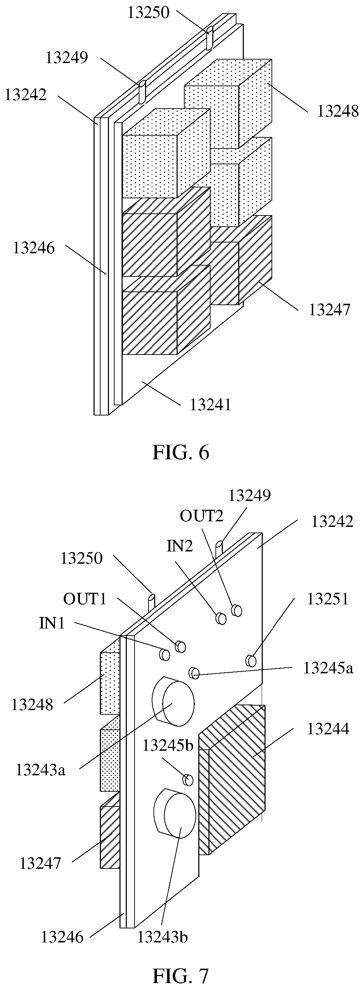

FIG. 6 is a diagram of a plate heat exchanger component according to an embodiment of this application. FIG. 7 is another diagram of a plate heat exchanger component according to an embodiment of this application. As shown in FIG. 5, FIG. 6, and FIG. 7, in the foregoing dual-heat management system, the plate heat exchanger component 1324 may include a first plate heat exchanger module 1324a and a second plate heat exchanger module 1324b. The first plate heat exchanger module 1324a and the second plate heat exchanger module 1324b are isolated from each other. The first refrigerant channel and the first water channel are disposed in the first plate heat exchanger module 1324a, and the second refrigerant channel and the second water channel are disposed in the second plate heat exchanger module 1324b. Therefore, the first plate heat exchanger module 1324a is used for the first heat management system, and the second plate heat exchanger module 1324b is used for the second heat management system. The first plate heat exchanger module 1324a and the second plate heat exchanger module 1324b are disposed independently of each other, so that a single heat management system can be maintained without affecting an operating status of the other heat management system.

In an embodiment, the first plate heat exchanger module 1324a may specifically include a first refrigerant substrate 13241 and a first water channel substrate 13242 that are opposite and fastened to each other. The first refrigerant channel is located on the first refrigerant substrate 13241, and the first water channel is located on the first water channel substrate 13242. Similarly, the second plate heat exchanger module 1324b may include a second refrigerant substrate and a second water channel substrate that are opposite and fastened to each other. The second refrigerant channel is located on the second refrigerant substrate, and the second water channel is located on the second water channel substrate. The first plate heat exchanger module 1324a and the second plate heat exchanger module 1324b integrate the functions such as the evaporation plate heat exchanger, the condensation plate heat exchanger, the water channel substrate, and the refrigerant substrate. This reduces the quantity of heat management components and pipelines, can save space, and reduces heat exchange between the fluid in the pipeline and the external environment, so that the heat dissipation efficiency of the heat dissipation system 13 is improved.

In an embodiment, the first refrigerant substrate 13241 and the second refrigerant substrate are of an integrated structure, and the first water channel substrate 13242 and the second water channel substrate are of an integrated structure, so that a structure of the plate heat exchanger component 1324 is simplified, and space occupied by the plate heat exchanger component 1324 is reduced. In this way, when internal space of the control chamber 1313 is sufficient, a compressor 1322 may also be disposed on one side that is of the plate heat exchanger component 1324 and that is away from the water pumps 1323, to implement a three-compressor structure of the heat dissipation system 13.

Still refer to FIG. 6 and FIG. 7. The plate heat exchanger component 1324 may further be provided with a multi-way valve, a gas-liquid separator, and an expansion valve, thereby simplifying a pipeline design and streamlining an installation operation. The first plate heat exchanger module 1324a is used as an example. Specifically, the first plate heat exchanger module 1324a includes the first refrigerant substrate 13241, the first water channel substrate 13242, and a third water channel substrate 13246 that are sequentially disposed, where the first water channel substrate 13242 is located on one side that is of the third water channel substrate 13246 and that faces the compressors 1322, and the first water channel substrate 13242 is provided with a first multi-way valve 13243a, a second multi-way valve 13243b, a first expansion valve 13245a, and a second expansion valve 13245b. A first water channel inlet IN1, a first water channel outlet OUT1, a second water channel inlet IN2, and a second water channel outlet OUT2 are disposed on a surface that is of the first water channel substrate 13242 and that faces the compressor 1322. The first water channel inlet IN1 and the first water channel outlet OUT1 are respectively connected to two ends of the first water channel, and the first water channel inlet IN1 and the first water channel outlet OUT1 separately communicate with a battery cooling channel, where either of the first water channel inlet IN1 and the first water channel inlet IN1 is connected to the first water pump 1323a. The second water channel inlet IN2 and the second water channel outlet OUT2 are respectively connected to two ends of the second water channel, and the second water channel inlet IN2 and the second water channel outlet OUT2 separately communicate with the liquid cooling unit 1321, where either of the second water channel inlet IN2 and the second water channel outlet OUT2 is connected to a heat dissipater 13211 of the liquid cooling unit 1321. In addition, the first plate heat exchanger module 1324a may further include a first gas-liquid separator 13244, and the first gas-liquid separator 13244 is located on one side that is of the third water channel substrate 13246 and that faces the compressors 1322. A cooler 13247 and a condenser 13248 are disposed on a surface that is of the first refrigerant substrate 13241 and that is away from the third water channel substrate 13246, and the cooler 13247 and the condenser 13248 separately communicate with the first refrigerant channel. The first refrigerant substrate 13241 is provided with a suction port 13249 and an air exhaust port 13250. The suction port 13249 and the air exhaust port 13250 are connected to two ends of the first refrigerant channel, and the suction port 13249 and the air exhaust port 13250 are separately connected to the compressors 1322. In addition, a fluorine injection nozzle 13251 is further disposed on a surface that is of the first water channel substrate 13242 and that faces the compressors 1322, and a refrigerant may be added to the first refrigerant channel through the fluorine injection nozzle 13251.

When the water pumps 1323 are disposed, the first water pump 1323a and the second water pump 1323b may be disposed opposite to each other in the width direction W. An axis of the first water pump 1323a in the width direction W and an axis of the second water pump 1323b in the width direction W do not overlap, and the first water pump 1323a is located on one side that is of the second water pump 1323b and that faces the plate heat exchanger component 1324. The first water pump 1323a is provided with a first inlet and a first outlet, and the first outlet is located at one end that is of the first water pump 1323a and that is close to the plate heat exchanger component 1324. The first outlet communicates with the first water channel, and the first inlet is configured to communicate with the battery cooling channel. The second water pump 1323b is provided with a second inlet and a second outlet, and the second inlet is located at one end that is of the second water pump 1323b and that is away from the plate heat exchanger component 1324. The second inlet communicates with the battery cooling channel, and the second outlet communicates with the second water channel. In this implementation, the first outlet of the first water pump 1323a is close to the plate heat exchanger component 1324, to reduce space occupied by a pipeline between the first water pump 1323a and the plate heat exchanger component 1324. The second inlet of the second water pump 1323b is far away from the plate heat exchanger component 1324, and may be directly connected to the battery cooling channel, to simplify connection and mounting of the second water pump 1323b and the battery cooling channel.

To reduce space occupied by the water pumps 1323, a size of the first water pump 1323a may be different from a size of the second water pump 1323b. Specifically, an area of a cross section that is of the first water pump 1323a and that is perpendicular to the width direction W is different from an area of a cross section that is of the second water pump 1323b and that is perpendicular to the width direction W. In this way, a flow volume of the first water pump 1323a may be different from a flow volume of the second water pump 1323b, so that the two heat management systems are set to different heat dissipation efficiency.

As shown in FIG. 4, in an embodiment, the liquid cooling unit 1321 may include the heat dissipater 13211 and a fan 13212. The fan 13212 is located on one side that is of the heat dissipater 13211 and that is away from the control chamber 1313. A filter is disposed on a surface of the heat dissipater 13211, to prevent small particles such as dust or dirt from entering the heat dissipater 13211 and affecting performance of the heat dissipater 13211. The plate heat exchanger component 1324 may further include a third water channel, and the heat dissipater 13211 communicates with the third water channel, to communicate with the heat dissipation loop. Specifically, the third water channel may be disposed on the first water channel substrate 13242 and the second water channel substrate, so that the two heat management systems may share one heat dissipation loop.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A heat dissipation system, comprising a container body and a heat management module, wherein the heat management module is disposed in the container body;
a partition plate is disposed in the container body, the partition plate separates internal space of the container body into a temperature control chamber and a control chamber, and in a height direction of the container body, the temperature control chamber is located above the control chamber;
the heat management module comprises at least two compressors, at least two water pumps, a plate heat exchanger component, and an electric control box that are located in the control chamber, the at least two compressors and the electric control box are sequentially disposed in a width direction of the container body, the plate heat exchanger component and the at least two water pumps are sequentially disposed in the width direction, the electric control box and the at least two water pumps are sequentially disposed in a length direction of the container body, and the at least two compressors and the at least two water pumps are separately connected to the plate heat exchanger component and are separately connected to the electric control box; and
the heat management module further comprises a liquid cooling unit located in the temperature control chamber, and the plate heat exchanger component and the electric control box are separately connected to the liquid cooling unit.

2. The heat dissipation system according to claim 1, wherein the at least two compressors, the at least two water pumps, the plate heat exchanger component, and the electric control box are distributed in an array.

3. The heat dissipation system according to claim 1 or 2, wherein the at least two compressors comprise a first compressor and a second compressor, and the first compressor and the second compressor are sequentially disposed in the width direction;
the at least two water pumps comprise a first water pump and a second water pump, and the first water pump and the second water pump are sequentially disposed in the width direction; and
the plate heat exchanger component comprises a first refrigerant channel, a second refrigerant channel, a first water channel, and a second water channel, the first compressor communicates with the first refrigerant channel, the second compressor communicates with the second refrigerant channel, the first water pump communicates with the first water channel, and the second water pump communicates with the second water channel.

4. The heat dissipation system according to claim 3, wherein the plate heat exchanger component comprises a first plate heat exchanger module and a second plate heat exchanger module, the first refrigerant channel and the first water channel are disposed in the first plate heat exchanger module, and the second refrigerant channel and the second water channel are disposed in the second plate heat exchanger module.

5. The heat dissipation system according to claim 4, wherein the first plate heat exchanger module comprises a first refrigerant substrate and a first water channel substrate that are opposite and fastened to each other, the first refrigerant channel is located on the first refrigerant substrate, and the first water channel is located on the first water channel substrate; and
the second plate heat exchanger module comprises a second refrigerant substrate and a second water channel substrate that are opposite and fastened to each other, the second refrigerant channel is located on the second refrigerant substrate, and the second water channel is located on the second water channel substrate.

6. The heat dissipation system according to claim 5, wherein the first refrigerant substrate and the second refrigerant substrate are of an integrated structure, and the first water channel substrate and the second water channel substrate are of an integrated structure.

7. The heat dissipation system according to any one of claims 3 to 6, wherein the first water pump and the second water pump are disposed opposite to each other in the width direction, an axis of the first water pump in the width direction and an axis of the second water pump in the width direction do not overlap, and the first water pump is located on one side that is of the second water pump and that faces the plate heat exchanger component;
the first water pump is provided with a first inlet and a first outlet, the first outlet is located at one end that is of the first water pump and that is close to the plate heat exchanger component, the first outlet communicates with the first water channel, and the first outlet is configured to communicate with a heat dissipation channel of a battery pack; and
the second water pump is provided with a second inlet and a second outlet, the second inlet is located at one end that is of the second water pump and that is away from the plate heat exchanger component, the second inlet communicates with the heat dissipation channel, and the second outlet communicates with the second water channel.

8. The heat dissipation system according to any one of claims 3 to 7, wherein an area of a cross section that is of the first water pump and that is perpendicular to the width direction is different from an area of a cross section that is of the second water pump and that is perpendicular to the width direction.

9. The heat dissipation system according to any one of claims 1 to 8, wherein one side that is of the electric control box and that is far away from the at least two compressors is in hinged connection to the container body.

10. The heat dissipation system according to any one of claims 1 to 9, wherein the liquid cooling unit comprises a heat dissipater and a fan, the fan is located on one side that is of the heat dissipater and that is away from the control chamber, and a filter is disposed on a surface of the heat dissipater; and
the plate heat exchanger component further comprises a third water channel, and the heat dissipater communicates with the third water channel.

11. The heat dissipation system according to any one of claims 1 to 10, wherein the container body comprises a top wall, a bottom wall, and four side walls that are enclosed, the top wall and the bottom wall are disposed in parallel, and the four side walls are perpendicular to the top wall; and
in the four side walls, a side wall located on one side that is of the electric control box and that is away from the at least two water pumps is provided with a cabinet door.

12. An energy storage system, comprising an energy storage cabinet, a power converter, and the heat dissipation system according to any one of claims 1 to 11, wherein
a plurality of battery packs are disposed in the energy storage cabinet;
the heat dissipation system is disposed at one end of the energy storage cabinet, the plate heat exchanger component is located on one side that is of the at least two compressors and that faces the energy storage cabinet, and the at least two water pumps are located on one side that is of the electric control box and that faces the energy storage cabinet; and
the power converter is configured to charge or discharge the plurality of battery packs in the energy storage cabinet.

13. The energy storage system according to claim 12, wherein the energy storage cabinet comprises a cabinet body, the plurality of battery packs are accommodated in the cabinet body, a battery cooling channel is provided in the cabinet body, and the at least two water pumps separately communicate with the battery cooling channel.
